# EUROPEAN PATENT APPLICATION

(11) **EP 4 300 193 A1**
(43) Date of publication of application: **03.01.2024**
(21) Application number: 22181325.6
(22) Date of filing: 27.06.2022
(51) Int. Cl.: G03F 9/00, G03F 7/20, G01N 21/47, G01N 21/956, G02B 7/34

(54) **FOCUS MEASURMENT AND CONTROL IN METROLOGY AND ASSOCIATED WEDGE ARRANGEMENT**

(71) Applicant: ASML Netherlands B.V., 5500 AH Veldhoven (NL)
(72) Inventor: ZHOU, Zili, 5500 AH Veldhoven (NL); DEN BOEF, Arie, Jeffrey, 5500 AH Veldhoven (NL)
(74) Representative: ASML Netherlands B.V.

(57) **Abstract**

Disclosed is a wedge arrangement comprising a plurality of wedge elements, arranged around an optical axis, the plurality of wedge elements comprising at least a first wedge element, a second wedge element and a third wedge element; wherein: said first wedge element comprises a first optical surface and second optical surface, wherein the first optical surface is planar and non-perpendicular to the optical axis and the second optical surface is non-planar such that said first wedge element has a non-linear thickness change; said second wedge element comprises a third optical surface and fourth optical surface which are each planar and are non-parallel; and said third wedge element comprises a fifth optical surface and sixth optical surface wherein the fifth optical surface is planar and non-perpendicular to the optical axis. Also disclosed is a metrology device which uses such a wedge arrangement in determining focus of measurement radiation during a measurement.

## Description

### BACKGROUND

### Field of the Invention

The present invention relates to a metrology apparatus and methods usable, for example, to perform metrology in the manufacture of devices by lithographic techniques. The invention further relates to such methods for monitoring focus of the measurement radiation in such a metrology apparatus.

### Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). Examples of dark field imaging metrology can be found in international patent applications US20100328655A1 and US2011069292A1 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In many typical metrology tools, a separate focus monitoring branch is used to measure or monitor focus of the measurement radiation on the target or structure being measured. However, this requires significant additional hardware (e.g., *inter alia* detectors, lenses beamsplitters and other optical elements). Such hardware adds considerable cost, complexity and bulk to the metrology tool.

It would be desirable to improve on such focus monitoring methods in metrology.

### SUMMARY OF THE INVENTION

The invention in a first aspect provides a wedge arrangement comprising a plurality of wedge elements, arranged around an optical axis, the plurality of wedge elements comprising at least a first wedge element, a second wedge element and a third wedge element; wherein: said first wedge element comprises a first optical surface and second optical surface, wherein the first optical surface is planar and non-perpendicular to the optical axis and the second optical surface is non-planar such that said first wedge element has a non-linear thickness change; said second wedge element comprises a third optical surface and fourth optical surface which are each planar and are non-parallel; and said third wedge element comprises a fifth optical surface and sixth optical surface wherein the fifth optical surface is planar and non-perpendicular to the optical axis.

The invention in a second aspect provides a metrology device comprising a detection branch, said detection branch comprising the wedge arrangement of the first aspect.

The invention in a third aspect provides a metrology device comprising: a processor; an illumination branch for illuminating a sample with measurement radiation; and a detection branch for detecting scattered radiation, the scattered radiation comprising said measurement radiation having been scattered by the sample, the detection branch comprising at least one detector for detecting said scattered radiation; wherein the detection branch further comprises a wedge arrangement operable to: separate at least non-zeroth order diffracted radiation within said scattered radiation from zeroth order radiation within the scattered radiation such that the non-zeroth order diffracted radiation and zeroth order scattered radiation are imaged on different regions of said at least one detector, separate a first portion of said zeroth order radiation from a second portion of said zeroth order radiation, such that said first portion of said zeroth order radiation and said second portion of said zeroth order radiation are imaged on different regions of said at least one detector so as to respectively form a first zeroth order image and a second zeroth order image; and impose defocus on at least one of said first portion of said zeroth order radiation and said second portion of said zeroth order radiation; wherein said processor is operable to determine a focus value of said measurement radiation on the sample from said first zeroth order image and a second zeroth order image.

The invention in a fourth aspect provides a method of determining a focus value of measurement radiation on a sample during a measurement of the sample, the method comprising: separating scattered radiation from the sample, having scattered from the sample following illumination of the sample with said measurement radiation, into at least non-zeroth order diffracted radiation, a first portion of zeroth order radiation and a second portion of zeroth order radiation; detecting at least one image of the non-zeroth order diffracted radiation, a first zeroth order image from the first portion of zeroth order radiation, and a second zeroth order image of the second portion of zeroth order radiation at separate regions of a detection plane; imposing a defocus on at least one of said first portion of said zeroth order radiation and said second portion of said zeroth order radiation; and determining the focus value of said measurement radiation on the sample from said first zeroth order image and a second zeroth order image.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus;
Figure 2 depicts a lithographic cell or cluster in which an inspection apparatus according to the present invention may be used; and
Figure 3 illustrates schematically an inspection apparatus adapted to perform angle-resolved scatterometry and dark-field imaging inspection methods;
Figure 4 illustrates a known arrangement for imaging four diffraction orders (pairs of first diffraction orders in each of the two substrate plane direction) using a metrology tool such as illustrated in Figure 3;
Figure 5 illustrates a known focus monitoring method for a metrology tool such as illustrated in Figure 3 and shows (a) a schematic illustration of a focus monitoring branch and (b) a known signal processing method for inferring focus using such a focus monitoring branch;
Figure 6 is a plot of fringe contrast against focus illustrating the basis of a known fringe contrast based focus monitoring method;
Figure 7 is a flow diagram and plot of a spatial frequency metric against focus illustrating the basis of a spatial frequency based focus monitoring method according to concepts disclosed herein; and
Figure 8 is a flow diagram and plot of a spatial frequency metric against focus illustrating a novel wedge arrangement and method according to an embodiment.

### DETAILED DESCRIPTION OF EXEMPLARY EMBODIMENTS

Before describing embodiments of the invention in detail, it is instructive to present an example environment in which embodiments of the present invention may be implemented.

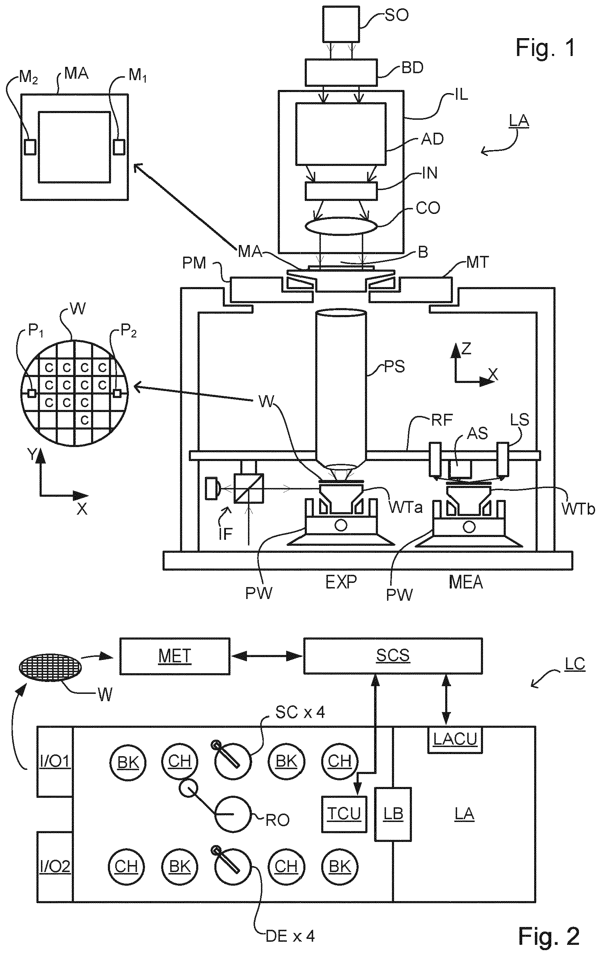

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can take many forms; the patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., reticle/mask) MA with respect to the path of the radiation beam B, e.g., after mechanical retrieval from a mask library, or during a scan.

Patterning device (e.g., reticle/mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties or parameters of interest such as overlay between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

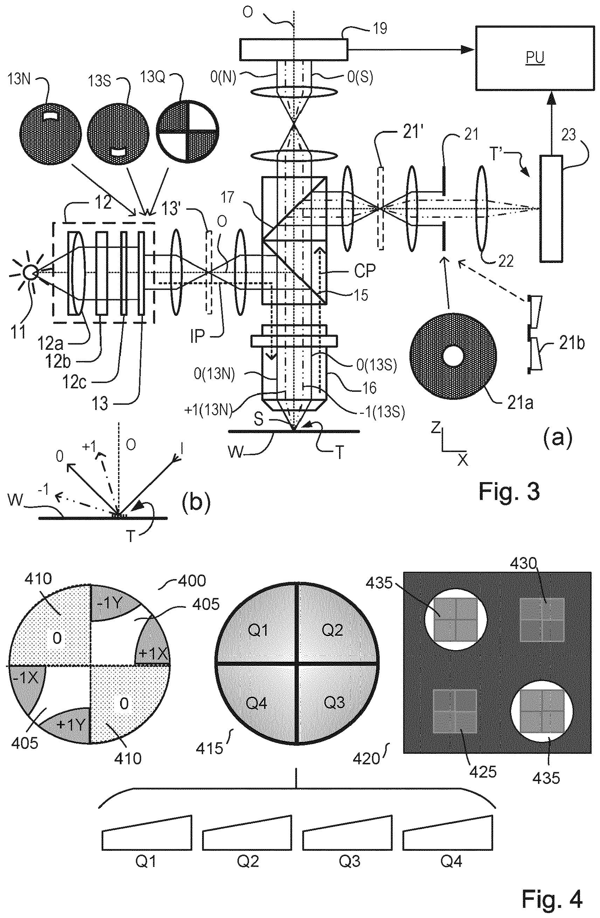

A metrology apparatus suitable for use in embodiments of the invention is shown in Figure 3(a). Note that this is only one example of a suitable metrology apparatus. An alternative suitable metrology apparatus may use EUV radiation such as, for example, that disclosed in WO2017/186483A1. Many other types of metrology apparatuses are known and may equally be used to implement the concepts disclosed herein. A target structure T and diffracted rays of measurement radiation used to illuminate the target structure are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. A specific alternative, aperture plate 13Q comprises a quartered illumination aperture where illumination is admitted via two diagonally opposed quadrants, the other two quadrants being blocked (the illumination and blocked quadrants may be swapped over from those shown). Such an arrangement may be used for simultaneous imaging of the +1 and -1 diffraction orders, and is described further in the aforementioned US2010201963A1. The rest of the pupil plane is desirably dark as any unnecessary light outside the desired illumination mode will interfere with the desired measurement signals.

As shown in Figure 3(b), target structure T is placed with substrate W normal to the optical axis O of objective lens 16. The substrate W may be supported by a support (not shown). A ray of measurement radiation I impinging on target structure T from an angle off the axis O gives rise to a zeroth order ray (solid line 0) and two first order rays (dot-chain line +1 and double dot-chain line -1), hereafter referred to as a pair of complementary diffraction orders. It should be noted that the pair of complementary diffraction orders may be any higher order pair; e.g., the +2, -2 pair etc. and is not limited to the first order complementary pair. It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target structure T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target structure T on sensor 23 (e.g. a CCD or CMOS sensor). In the second measurement branch, an aperture stop 21a is provided in a plane 21 that is conjugate to the pupil-plane. Aperture stop 21a functions to block the zeroth order diffracted beam so that the image of the target formed on sensor 23 is formed only from the -1 or +1 first order beam. Instead of a simple aperture stop 21a, the metrology tool may use instead a wedge arrangement 21b which separates the first orders and zeroth order, so that they can be imaged separately (apart) on the detector 23. Such an arrangement is described in the aforementioned US2011102753A1 and can be used (e.g., in combination with quartered illumination aperture 13Q) to simultaneously acquire +1 and -1 diffraction orders in one or both directions of the substrate plane.

The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

Position errors may occur due to an overlay error (often referred to as "overlay"). The overlay is the error in placing a first feature during a first exposure relative to a second feature during a second exposure. The lithographic apparatus minimizes overlay by aligning each substrate accurately to a reference prior to patterning, e.g., by measuring positions of alignment marks on the substrate using an alignment sensor; and by using feedback corrections for the exposure process; e.g., based on measuring overlay on metrology targets post-exposure using a suitable metrology tool such as illustrated in Figure 3(a).

One known metrology method which may be performed using a metrology tool such as illustrated in Figure 3(a) is known as diffraction based overlay (DBO) or micro-diffraction based overlay (µDBO). Such µDBO techniques use the imaging branch (the branch through detector 23) of the metrology tool, and determine asymmetry in a structure based on an intensity asymmetry or intensity difference between a first diffraction order and a second diffraction order of a pair of complementary pair of diffraction orders (typically a complementary pair of first diffraction orders, i.e., the first diffraction order may comprise the +1 order and the second diffraction order may comprise the -1 order as illustrated in Figure 3(b)). As such, in this context, the terms "first" and "second" do not refer to a diffraction order number and are simply being used to distinguish the two diffractions orders of a complementary pair, noting that the first and second diffraction orders may be the +2 and -2 diffraction orders or a higher pair of complementary diffraction orders. The zeroth order (specular radiation) is typically blocked or diverted elsewhere (e.g., to another part of the detector for monitoring purposes); it is not used in µDBO metrology. The main "images" used for parameter of interest inference are formed only from higher (e.g., first) diffraction orders. The asymmetry of the structure may be used to infer a parameter of interest such as overlay or focus, depending on the target design.

Overlay is only one parameter of interest measurable using such techniques. Another parameter of interest may be exposure focus. This exposure focus may be measured using diffraction based focus (DBF) or micro-diffraction based focus (µDBF) metrology. The measurement principle for µDBO and µDBF is essentially the same (measurement of target asymmetry via intensity asymmetry in complementary diffraction orders). The main difference in the two techniques is in the targets: µDBO targets have an overlay dependent asymmetry and µDBF targets have an exposure focus based asymmetry. Note that exposure focus and DBF/µDBF metrology in this context is different to the focus of the focus monitoring methods disclosed herein. DBF/µDBF infers the actual focus of the exposure radiation (scanner focus) on the substrate from the exposed target, i.e., the scanner focus when the target (and other structures) was exposed on the wafer. The concepts disclosed herein relate to metrology tool focus, or the focus of measurement radiation on the wafer during a measurement. All mentions of µDBO or DBO below should be understood to include measurements of any parameter of interest using any diffraction based imaging metrology method based on imaging single diffraction orders, including DBF/µDBF.

Figure 4 illustrates a known arrangement of using a wedge arrangement (e.g., wedge arrangement 21b described above) to simultaneously image, on separate regions of a detector (or separate detectors), both diffraction orders of a +1/-1 complementary pair of diffraction orders and the zeroth order. The detection pupil plane 400 (or conjugate pupil plane to the objective detection pupil plane) may be divided into four wedge elements or quadrants (e.g., by using a quartered illumination aperture in the illumination branch such as illumination aperture 13Q as described above), where two quadrants 405 correspond with the zeroth order 0 and two quadrants 410 correspond to the wanted diffraction orders +1X, -IX, -1Y, +1Y received from X oriented and Y oriented targets respectively (where X and Y are the two perpendicular directions of the substrate plane). The wedge arrangement 415 maybe located in this (conjugate) detection pupil plane and comprise four (similar) quadrants Q1, Q2, Q3, Q4, each quadrant comprising a respective optical wedge oriented to separate the angle of the zeroth orders from the wanted diffraction orders so that they are located at four different positions in µDBO image plane. Each wedge is shown in cross-section at the bottom of the picture, similarly oriented. The resultant image 420 comprises a +1 image 425, a -1 image 430 and two (similar) zeroth order images 435. Note that, by including only half of the first order diffracted radiation in each of the +1 and -1 images 425, 430, the 'images' referred to here are not conventional dark field microscopy images. The individual grating lines will not be resolved. Each grating will be represented simply by an area of a certain intensity level, and the difference between the intensity levels of image 425 and image 430 (per direction) can be used to infer target asymmetry and therefore the parameter of interest.

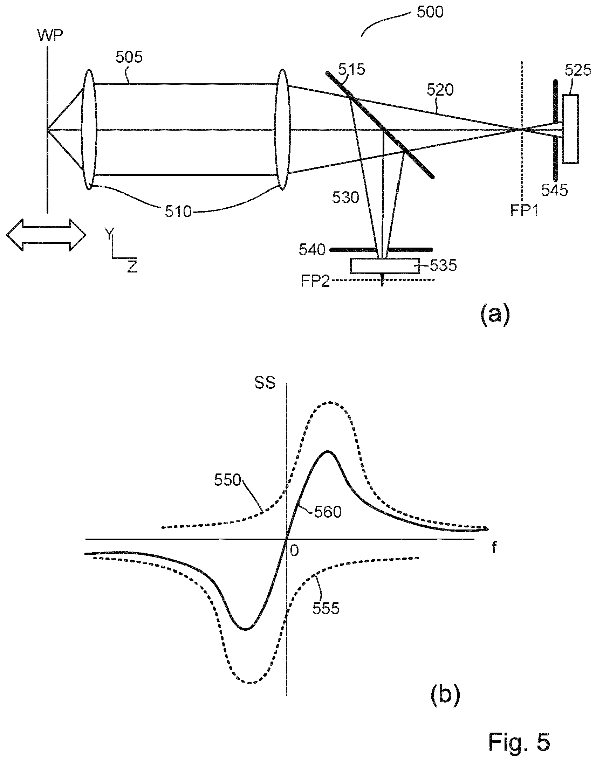

Figure 5 illustrates a known focus monitoring arrangement which may be employed on a metrology device such as illustrated in Figure 3(a). Such a focus monitoring arrangement may comprise a focusing branch 500, as illustrated in Figure 5(a), which employs a con-focal focusing principle. The hardware shown in Figure 5(a) is a highly simplified schematic showing a wafer plane WP which may be moved as indicated by the arrow for focus. Scattered radiation 505 from the wafer may be collected by the objective lens arrangement 510 (e.g., via a beamsplitter, not shown), and split using beamsplitter 515. A first split portion 520 of the scattered radiation is focused at a first focus plane FP1 ahead of a first detector 525 and at a second split portion 530 of the scattered radiation and is focused at a second focus plane FP2 behind a second detector 535. A respective pinhole or aperture 540, 545 is located before each detector 525, 535.

Figure 5(b) illustrates how focus may be inferred from the detected signals captured by first detector 525 and second detector 535. The Figure shows a plot of signal strength (e.g., amplitude or intensity) SS against defocus f (centered on zero defocus). The dotted lines comprise a first signal 550 from first detector 525 and a second signal 555 from second detector 535. A difference signal 560 between these signals 550, 555 has a linear dependence with defocus near the zero-defocus regime. This signal can be determined and used to detect focus of the measurement illumination on the wafer with good sensitivity.

An issue with such a focusing arrangement is that it requires an additional branch of hardware which is significantly more complex than illustrated. Reduction of the cost, bulk and complexity of such a focusing branch is desirable. Additionally, a present implementation of such a focusing branch uses only two wavelengths to perform the focusing, which does not properly represent all wavelengths used for a measurement considering chromatic aberrations, Additionally, these two wavelengths cannot be used in the imaging branch for a µDBO measurement.

An alternative known method for focus monitoring in a metrology tool may use fringe contrast. Normally in µDBO imaging, there are no fringes present as only the zeroth or first diffraction order is allowed in any one quadrant. When diffraction orders higher than the first orders are present in one quadrant, e.g. by using a low wavelength/target pitch ratio, the target's grating lines will be imaged in the quadrant with visible fringes. The contrast of the line fringes is dependent on the defocus, i.e., the highest fringe contrast achieved at the best focus.

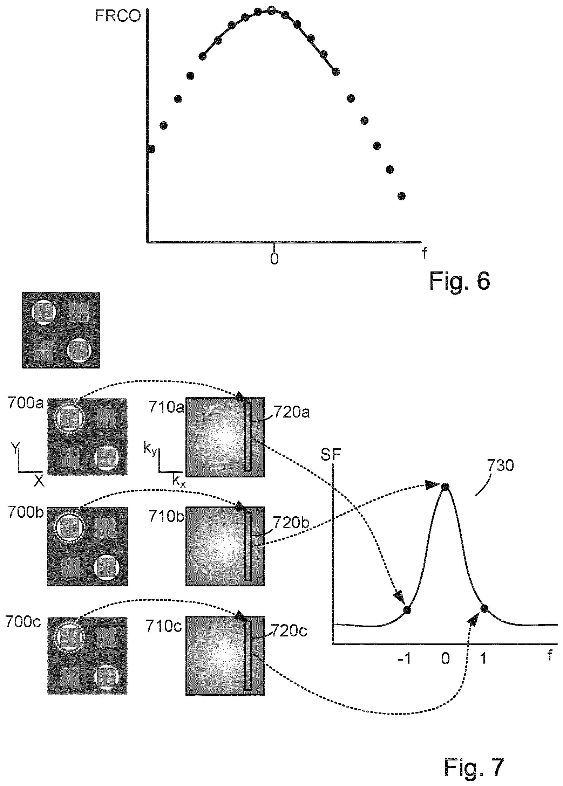

Figure 6 is a plot of first order fringe contrast FRCO against defocus f which shows this dependence. This dependence allows focus detection/calibration; however it cannot be used in real-time during a µDBO measurement because µDBO images should not comprise diffraction orders higher than the first orders. In addition, it can be seen from the plot that the lowest sensitivity is at the near-best-focus regime, and that that this method can only measure the magnitude of the defocus, not its direction. Also, a large target is required for fringe contrast analysis, which is undesirable for µDBO.

To address these issues, a method and metrology arrangement is proposed which uses a focus-dependent metric based differential detection method. The focus-dependent metric may comprise spatial frequency or fringe contrast, for example. Such a method may use a new design of wedge arrangement in a detection pupil plane or conjugate thereof. The concept enables real-time focus detection in the imaging branch (e.g., when performing µDBO/µDBF metrology or similar dark-field metrology techniques) instead of using a separate focus monitoring branch.

The effect of defocus is to blur an image, and thus reduce its higher spatial frequency components. This is also true for µDBO/µDBF images or similar images. As such, by determining spatial frequency from such images, focus can be determined.

Figure 7 illustrates the basic principle behind (at least some of) the concepts disclosed herein. Images 700a, 700b, 700c are shown, each corresponding to a respective different metrology focus value +1, 0, -1 (units are arbitrary), where 0 corresponds to best focus. Each of these images (or a region thereof) can be Fourier transformed (e.g., a 2D transformation such as a 2D Fast Fourier Transform FFT) to obtain respective spatial frequencies 710a, 710b, 710c. In the example shown, the image regions transformed may comprise one or both of the zeroth order images or a region of one or both of the zeroth order images. This enables focus monitoring on detected radiation not used in parameter inference. A plot 730 of a spatial frequency metric SF against focus f is shown. The spatial frequency metric may comprise, for example, an intensity or amplitude of a corresponding frequency component 720a, 720b, 720c from each spatial frequency representation 710a, 710b, 710c, or a combination of corresponding frequency components from each spatial frequency representation 710a, 710b, 710c. The specific frequency component shown here is arbitrary and specifically here is a kₓ direction component in pupil space corresponding to the X-direction. It can be seen that the spatial frequency metric SF has a (nonlinear) dependence with defocus f. It is proposed to use this dependence to measure the metrology focus.

The spatial frequency metric used in methods described herein may relate to a single frequency component, a single frequency component per direction (e.g., in the kₓ and the k_{y} directions) or more than one spatial frequency (e.g., per direction or otherwise) of each image. For example a large number of frequencies (e.g., any frequencies other than the lowest frequency in the center of each transformed image 710a, 710b, 710c) can be used. The signals from the different spatial frequencies can be averaged or otherwise combined to obtain the spatial frequency metric.

It may be that some spatial frequencies are more sensitive to defocus than the other spatial frequencies in certain use cases. As such, a proposed method may comprise an optional spatial frequency selection step to optimize defocusing control performance.

In particular, the spatial frequency metric used in methods described herein may comprise a difference spatial frequency metric comprising a difference from a first spatial frequency metric from a first zeroth order image and a second spatial frequency metric from a second zeroth order image, the first and second zeroth order images being subject to a different focus (e.g., in a detection pupil plane or conjugate thereof).

A practical implementation of this principle may use a novel wedge arrangement to obtain a substantially linear, or at least monotonic, dependence of the (difference) spatial frequency metric with focus over a focus range of interest (e.g., a focus range around best focus and including an expected focus error range for the metrology tool). The proposed wedge arrangement may be similar to wedge arrangement 415 described above, but with at least one of the wedge elements (e.g., quadrants) corresponding to a zeroth order region in the detection pupil plane having a surface curvature so as to induce a defocused wavefront for its respective zeroth order. For example, the curvature may be on the opposite surface to an angled planar surface, the angled planar surface for displacing the zeroth order in the pupil plane so as to separate its image from the first order images and complementary zeroth order image in the image plane. This enables a differential signal to be determined between spatial frequency metrics derived respectively from the two zeroth order images, which have a monotonic and/or substantially linear relationship with focus.

As such, the wedge arrangement may comprise a plurality of wedge elements, arranged around an optical axis, the plurality of wedge elements comprising at least a first wedge element, a second wedge element and a third wedge element; wherein: the first wedge element comprises a first optical surface and second optical surface, wherein the first optical surface is planar and non-perpendicular to the optical axis and the second optical surface is non-planar such that said first wedge element has a non-linear thickness change; the second wedge element comprises a third optical surface and fourth optical surface which are each planar and are non-parallel; and the third wedge element comprises a fifth optical surface and sixth optical surface wherein the fifth optical surface is planar and non-perpendicular to the optical axis. The wedge arrangement may also comprise a fourth wedge element comprising a seventh optical surface and an eighth optical surface which are each planar and are non-parallel.

In a convenient arrangement, the first wedge element may correspond to a first zeroth order pupil region, the second wedge element may correspond to a first diffracted radiation pupil region, the third wedge element may correspond to a second zeroth order pupil region and a fourth wedge element may correspond to a second diffracted radiation pupil region. The terms "first diffracted radiation pupil region" and "second diffracted radiation pupil region" are so called to differentiate the pupil regions from each other and the terms "first" and "second" do not refer to a diffraction order number. As will be appreciated, the first diffracted radiation pupil region and second diffracted radiation pupil region will typically correspond to a respective diffraction order of a pair of complementary diffraction orders, e.g., such that the first diffracted radiation pupil region corresponds with the +1 diffraction order and the second diffracted radiation pupil region corresponds with the -1 diffraction order.

In a convenient arrangement, the first wedge element and third wedge element may respectively comprise a curved surface with opposite curvature so as to impart defocus in opposite directions. In such an arrangement, optionally, the curvature (and therefore defocus) imparted by first wedge element and third wedge element may be equal in magnitude.

Each of the first wedge element and third wedge element may direct zeroth order radiation to a different region of the image plane (detector plane) so as to obtain a first zeroth order image and second zeroth order image. Respective first and second spatial frequency metrics for each of the first zeroth order image and second zeroth order image can be determined and a difference of these spatial frequency metrics used to determine focus.

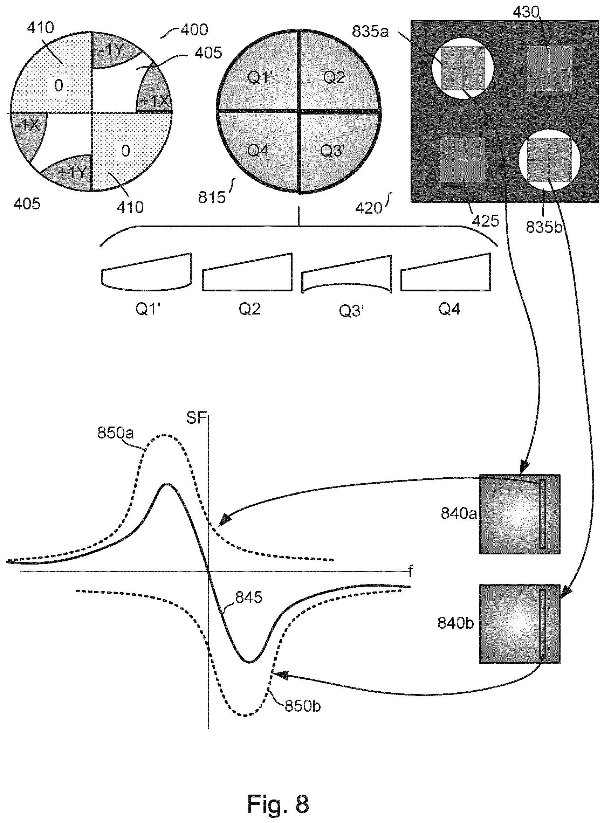

Figure 8 is a schematic drawing illustrating such a method and arrangement. The top portion of the Figure corresponds to Figure 4, and like elements will not be described again. The main difference is wedge arrangement 815, for which the surface curvature of the Q1' and Q3' quadrants (wedge elements) each have a curved surface of opposite curve, e.g., quadrant Q1' has a convex surface which induces a negative defocus wavefront, and quadrant Q3' has concave surface which induces a positive defocus wavefront. The magnitude of the defocus applied may be the same for both quadrants Q1' and Q3'.

Image 420 will now comprise a first zeroth order image 835a and a second zeroth order image 835b, each corresponding to a different imposed defocus. Each of these images can be Fourier transformed (e.g., a 2D FFT) to obtain respective transformed images or spatial frequency representations 840a, 840b. From each of these spatial frequency representations 840a, 840b, a respective spatial frequency metric can be determined (e.g., from one or more spatial frequency components as described). The spatial frequency metric used for focus inference may then comprise the difference of these spatial frequency metrics.

Focus inference may be achieved by reference to a previously calibrated relationship 845 describing variation of the spatial frequency metric with focus. This relationship may be obtained from a difference of two calibration relationships 850a, 850b describing variation of the spatial frequency metric for each defocused zeroth image with focus. Note that respective peaks in the calibration relationships 850a, 850b are shifted in opposite directions with respect to best focus.

The methods described herein may comprise an initial calibration phase to determine calibrated relationship 845. The calibration may comprise obtaining a set of first zeroth order images and a set of second zeroth order images, each set imaged during a measurement of a target at corresponding different focus settings (e.g., through focus), determining a relationship of a spatial frequency metric (e.g., via Fourier transformation) through focus for each of the sets of images, and determining calibrated relationship 845 as a difference of these two relationships. Calibration may be performed for each application, e.g., for each stack and/or target type, and the appropriate calibrated relationship used to infer inference.

The differential zeroth order wedge arrangement disclosed herein may be used in an alternative focus inference method based on fringe contrast measurement. Such a method may comprise creating fringes in zeroth order pupil regions. This may be achieved by capturing diffraction orders greater than the first diffraction orders in the zeroth order quadrants; e.g., by using a small measurement wavelength to target pitch ratio. A respective first and second fringe contrast metric (e.g., a measure of fringe contrast) can be determined from the resultant first zeroth order image and second zeroth order image, as imaged on the detector. A difference fringe contrast metric comprising a difference of the first fringe contrast metric and second fringe contrast metric can be determined and used to infer focus based on a calibrated relationship between the fringe contrast metric (difference fringe contrast metric) and focus. This relationship can be determined in a similar calibration phase to that already described, but determined for fringe contrast rather than spatial frequency. This calibrated relationship will show a monotonic and/or linear dependence with focus over a focus range of interest and provides a much higher focus sensitivity than known fringe contrast methods previously described. However, such an embodiment cannot be used during a µDBO or µDBF measurement because the additional diffraction orders (≥2 orders) will also be present in 1st order quadrants.

In all embodiments, the measured focus value can be used by the metrology device to control focus (e.g., move the wafer with respect to the measurement beam) so as to minimize defocus. All determination steps, processing steps and mathematical steps may be performed by a processor of the metrology device.

The concepts disclosed herein allows detection of focus in a metrology tool, and more specifically an imaging branch of a metrology tool which detects a focused image of the target on a detector. This means that a separate focus monitoring branch is not required, reducing cost, bulk and system complexity. Additionally, the proposed methods enables detection of focus at all used wavelengths (i.e., all wavelengths of the measurement radiation), which is an improvement over a present implementation of focus monitoring branch which uses only two wavelengths for focus monitoring. Also, the frequency differential detection can be used in real-time during a measurement (e.g., a µDBO or µDBF measurement) does not require having imaging fringes in the uDBO image, thus it can be used during uDBO detection, and has not requirement on wavelength/pitch ratio, nor target size.

The fringe contrast differential detection method has advantages over the present fringe contrast based methods in that the differential detection provides a linear regime near the zero-focus, and thus provides a much higher focus detection sensitivity and the direction of the defocus. The method has been described in terms of measuring a structure or target on a substrate. However, the method may be applied to measurement of any sample, and for example, may include measuring focus during a measurement on a flat area (e.g., a thin film sample).

Further embodiments are disclosed in the subsequent list of numbered clauses:
1. A wedge arrangement comprising a plurality of wedge elements, arranged around an optical axis, the plurality of wedge elements comprising at least a first wedge element, a second wedge element and a third wedge element; wherein:
   said first wedge element comprises a first optical surface and second optical surface, wherein the first optical surface is planar and non-perpendicular to the optical axis and the second optical surface is non-planar such that said first wedge element has a non-linear thickness change;
   said second wedge element comprises a third optical surface and fourth optical surface which are each planar and are non-parallel; and
   said third wedge element comprises a fifth optical surface and sixth optical surface wherein the fifth optical surface is planar and non-perpendicular to the optical axis.
2. A wedge arrangement as defined in clause 1, wherein the sixth optical surface is non-planar such that said third wedge element has a non-linear thickness change.
3. A wedge arrangement as defined in clause 2, wherein said second optical surface is convex and said sixth optical surface is concave.
4. A wedge arrangement as defined in clause 3, wherein a magnitude of defocus imposed by said first wedge element and a magnitude of defocus imposed by said second wedge element is the substantially the same.
5. A wedge arrangement as defined in any preceding clause, wherein said plurality of wedge elements are arranged substantially in the same plane around said optical axis.
6. A wedge arrangement as defined in any preceding clause, further comprising a fourth wedge element comprising a seventh optical surface and an eighth optical surface which are each planar and are non-parallel.
7. A wedge arrangement as defined in clause 6, wherein each wedge element comprises a quadrant configuration and the plurality of wedge elements are arranged in said wedge arrangement in a circular configuration.
8. A metrology device comprising a detection branch, said detection branch comprising the wedge arrangement of any preceding clause and at least one detector.
9. A metrology device as defined in clause 8, wherein said at least one detector is operable to detect at least a first zeroth order image from zeroth order radiation of said scattered radiation which was displaced by said first wedge element and a second zeroth order image from zeroth order radiation of said scattered radiation which was displaced by said third wedge element.
10. A metrology device as defined in clause 9, wherein the metrology device further comprises a processor operable to:
   determine a first focus-dependent metric from said first zeroth order image and a second focus-dependent metric from said second zeroth order image;
   determine a difference focus-dependent metric from a difference of said first focus-dependent metric and said second focus-dependent metric; and
   determine a focus value of measurement radiation on a sample being measured from said difference focus-dependent metric.
11. A metrology device as defined in clause 10, wherein the first focus-dependent metric, second focus-dependent metric and difference focus-dependent metric each comprise a spatial frequency metric related to a spatial frequency of the first zeroth order image and second zeroth order image.
12. A metrology device as defined in clause 11, wherein the processor is operable to Fourier transform each of said first zeroth order image and second zeroth order image and to determine said first focus-dependent metric and said second focus-dependent metric.
13. A metrology device as defined in clause 10, wherein the first focus-dependent metric, second focus-dependent metric and difference focus-dependent metric each comprise a fringe contrast metric related to a fringe contrast of the first zeroth order image and second zeroth order image.
14. A metrology device as defined in any of clauses 10 to 13, wherein said processor is operable to determine said focus value by referencing to a calibrated relationship between the difference focus-dependent metric and focus.
15. A metrology device as defined in any of clauses 10 to 14, wherein said at least one detector is operable to detect non-zeroth order diffracted radiation on said detector; and
   determine a parameter of interest from said non-zeroth order diffracted radiation.
16. A metrology device as defined clause 15, comprising determining said parameter of interest and said focus value from a single image acquisition on said at least one detector.
17. A metrology device as defined in clause 15 or 16, wherein said first zeroth order image, said second zeroth order image, a first diffraction order image of a first diffraction order of a pair of complementary diffraction orders and a second diffraction order image of a second diffraction order of the pair of complementary diffraction orders are detected on separate regions on said at least one detector.
18. A metrology device as defined in clause 17, wherein said first diffraction order is a +1 diffraction order and said second diffraction order is a -1 diffraction order .
19. A metrology device as defined in any of clauses 10 to 18 being operable to use said focus value to control focus and minimize defocus of said measurement radiation on the sample.
20. A metrology device as defined in any of clauses 8 to 19, wherein said wedge arrangement is comprised within a pupil plane of said detection branch or a conjugate thereof.
21. A metrology device comprising:
   a processor;
   an illumination branch for illuminating a sample with measurement radiation; and
   a detection branch for detecting scattered radiation, the scattered radiation comprising said measurement radiation having been scattered by the sample, the detection branch comprising at least one detector for detecting said scattered radiation;
   wherein the detection branch further comprises a wedge arrangement operable to:
      separate at least non-zeroth order diffracted radiation within said scattered radiation from zeroth order radiation within the scattered radiation such that the non-zeroth order diffracted radiation and zeroth order scattered radiation are imaged on different regions of said at least one detector,
      separate a first portion of said zeroth order radiation from a second portion of said zeroth order radiation, such that said first portion of said zeroth order radiation and said second portion of said zeroth order radiation are imaged on different regions of said at least one detector so as to respectively form a first zeroth order image and a second zeroth order image; and
      impose defocus on at least one of said first portion of said zeroth order radiation and said second portion of said zeroth order radiation;
   wherein said processor is operable to determine a focus value of said measurement radiation on the sample from said first zeroth order image and a second zeroth order image.
22. A metrology device as defined in clause 21, wherein the processor is operable to determine a first focus-dependent metric from said first zeroth order image and a second focus-dependent metric from said second zeroth order image;
   determine a difference focus-dependent metric from a difference of said first focus-dependent metric and said second focus-dependent metric; and
   determine the focus value of said measurement radiation on the sample from said difference focus-dependent metric.
23. A metrology device as defined in clause 22, wherein the first focus-dependent metric, second focus-dependent metric and difference focus-dependent metric each comprise a spatial frequency metric related to a spatial frequency of the first zeroth order image and second zeroth order image.
24. A metrology device as defined in clause 23, wherein the processor is operable to Fourier transform each of said first zeroth order image and second zeroth order image and to determine said first focus-dependent metric and said second focus-dependent metric
25. A metrology device as defined in clause 22, wherein the first focus-dependent metric, second focus-dependent metric and difference focus-dependent metric each comprise a fringe contrast metric related to a fringe contrast of the first zeroth order image and second zeroth order image.
26. A metrology device as defined in any of clauses 22 to 25, wherein said processor is operable to determine said focus value by referencing to a calibrated relationship between the difference focus-dependent metric and focus.
27. A metrology device as defined in any of clauses 21 to 26, wherein said wedge arrangement comprises a plurality of wedge elements, arranged around an optical axis of the detection branch, the plurality of wedge elements comprising at least a first wedge element arranged to divert said first portion of said zeroth order radiation to a first region on said at least one detector, a second wedge element arranged to divert at least a portion of said non-zeroth order diffracted radiation to a second region on said at least one detector and a third wedge element arranged to divert said second portion of said zeroth order radiation to a third region on said at least one detector.
28. A metrology device as defined in clause 26, wherein:
   said first wedge element comprises a first optical surface and second optical surface, wherein the first optical surface is planar and non-perpendicular to the optical axis and the second optical surface is non-planar such that said first wedge element has a non-linear thickness change so as to impose defocus on said first portion of said zeroth order radiation;
   said second wedge element comprises a third optical surface and fourth optical surface which are each planar and are non-parallel; and
   said third wedge element comprises a fifth optical surface and sixth optical surface wherein the fifth optical surface is planar and non-perpendicular to the optical axis.
29. A metrology device as defined in clause 28, wherein the sixth optical surface is non-planar such that said third wedge element has a non-linear thickness change so as to impose a defocus on said second portion of said zeroth order radiation.
30. A metrology device as defined in clause 29, wherein said second optical surface is convex and the sixth optical surface is concave.
31. A metrology device as defined in clause 30, wherein a magnitude of the defocus imposed by said first wedge element and the defocus imposed by said second wedge element is the substantially the same.
32. A metrology device as defined in any of clauses 27 to 31, wherein said plurality of wedge elements are arranged substantially in a common pupil plane of the detection branch, or conjugate thereof, around said optical axis.
33. A metrology device as defined in any of clauses 27 to 32, wherein said wedge arrangement further comprises a fourth wedge element comprising a seventh optical surface and eighth optical surface which are each planar and are non-parallel.
34. A metrology device as defined in clause 33, wherein each wedge element comprises a quadrant configuration and the plurality of wedge elements are arranged in said wedge arrangement in a circular configuration.
35. A metrology device as defined in clause 33 or 34, wherein said second wedge element is arranged to divert a first diffraction order of a pair of complementary diffraction orders to said second region on said at least one detector and said fourth wedge element is arranged to divert a second diffraction order of the pair of complementary diffraction orders to a fourth region on said at least one detector.
36. A metrology device as defined in clause 35, wherein said first diffraction order is a +1 diffraction order and said second diffraction order is a -1 diffraction order.
37. A metrology device as defined in clause 35 or 36, wherein the processor is operable to determine a parameter of interest from the detected first diffraction order and the detected second diffracted order.
38. A metrology device as defined in clause 37, wherein the processor is operable to determine said parameter of interest and said focus value from a single image acquisition on said at least one detector.
39. A metrology device as defined in any of clauses 21 to 38, being operable to use said focus value to control focus and minimize defocus of said measurement radiation on the sample
40. A method of determining a focus value of measurement radiation on a sample during a measurement of the sample, the method comprising:
   separating scattered radiation from the sample, having scattered from the sample following illumination of the sample with said measurement radiation, into at least non-zeroth order diffracted radiation, a first portion of zeroth order radiation and a second portion of zeroth order radiation;
   detecting at least one image of the non-zeroth order diffracted radiation, a first zeroth order image from the first portion of zeroth order radiation, and a second zeroth order image of the second portion of zeroth order radiation at separate regions of a detection plane;
   imposing a defocus on at least one of said first portion of said zeroth order radiation and said second portion of said zeroth order radiation; and
   determining the focus value of said measurement radiation on the sample from said first zeroth order image and a second zeroth order image.
41. A method as defined in clause 40, wherein said step of determining the focus value, comprises:
   determining a first focus-dependent metric from said first zeroth order image and a second focus-dependent metric from said second zeroth order image;
   determining a difference focus-dependent metric from a difference of said first focus-dependent metric and said second focus-dependent metric; and
   determining a focus value of said measurement radiation on the sample from said difference focus-dependent metric
42. A method as defined in clause 41, wherein the first focus-dependent metric, second focus-dependent metric and difference focus-dependent metric each comprise a spatial frequency metric related to a spatial frequency of the first zeroth order image and second zeroth order image.
43. A method as defined in clause 42, comprising Fourier transforming each of said first zeroth order image and second zeroth order image and to determine said first focus-dependent metric and said second focus-dependent metric
44. A method as defined in clause 41, wherein the first focus-dependent metric, second focus-dependent metric and difference focus-dependent metric each comprise a fringe contrast metric related to a fringe contrast of the first zeroth order image and second zeroth order image.
45. A method as defined in any of clauses 41 to 44, comprising determining said focus value by referencing to a calibrated relationship between the difference focus-dependent metric and focus.
46. A method as defined in any of clauses 40 to 45, comprising determining a parameter of interest from said non-zeroth order diffracted radiation.
47. A method as defined clause 46, comprising determining said parameter of interest and said focus value from a single image acquisition.
48. A method as defined in any of clauses 41 to 47, comprising separating said non-zeroth order diffracted radiation into a first diffraction order of a pair of complementary diffraction orders and a second diffraction order of the pair of complementary diffraction orders and detecting the first diffraction order and second diffraction order on separate regions on said at least one detector.
49. A method as defined in clause 48, wherein said first diffraction order is a +1 diffraction order and said second diffraction order is a -1 diffraction order
50. A method as defined in any of clauses 40 to 49, comprising using said focus value to control focus and minimize defocus of said measurement radiation on the sample.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The term target should not be construed to mean only dedicated targets formed for the specific purpose of metrology. The term target should be understood to encompass other structures, including product structures, which have properties suitable for metrology applications.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A wedge arrangement comprising a plurality of wedge elements, arranged around an optical axis, the plurality of wedge elements comprising at least a first wedge element, a second wedge element and a third wedge element; wherein:
said first wedge element comprises a first optical surface and second optical surface, wherein the first optical surface is planar and non-perpendicular to the optical axis and the second optical surface is non-planar such that said first wedge element has a non-linear thickness change;
said second wedge element comprises a third optical surface and fourth optical surface which are each planar and are non-parallel; and
said third wedge element comprises a fifth optical surface and sixth optical surface wherein the fifth optical surface is planar and non-perpendicular to the optical axis.

2. A wedge arrangement as claimed in claim 1, wherein the sixth optical surface is non-planar such that said third wedge element has a non-linear thickness change.

3. A wedge arrangement as claimed in claim 2, wherein said second optical surface is convex and said sixth optical surface is concave.

4. A wedge arrangement as claimed in claim 3, wherein a magnitude of defocus imposed by said first wedge element and a magnitude of defocus imposed by said second wedge element is the substantially the same.

5. A wedge arrangement as claimed in any preceding claim, wherein said plurality of wedge elements are arranged substantially in the same plane around said optical axis.

6. A wedge arrangement as claimed in any preceding claim, further comprising a fourth wedge element comprising a seventh optical surface and an eighth optical surface which are each planar and are non-parallel.

7. A wedge arrangement as claimed in claim 6, wherein each wedge element comprises a quadrant configuration and the plurality of wedge elements are arranged in said wedge arrangement in a circular configuration.

8. A metrology device comprising a detection branch, said detection branch comprising the wedge arrangement of any preceding claim and at least one detector.

9. A metrology device as claimed in claim 8, wherein said at least one detector is operable to detect at least a first zeroth order image from zeroth order radiation of said scattered radiation which was displaced by said first wedge element and a second zeroth order image from zeroth order radiation of said scattered radiation which was displaced by said third wedge element.

10. A metrology device as claimed in claim 9, wherein the metrology device further comprises a processor operable to:
determine a first focus-dependent metric from said first zeroth order image and a second focus-dependent metric from said second zeroth order image;
determine a difference focus-dependent metric from a difference of said first focus-dependent metric and said second focus-dependent metric; and
determine a focus value of measurement radiation on a sample being measured from said difference focus-dependent metric.

11. A metrology device as claimed in claim 10, wherein the first focus-dependent metric, second focus-dependent metric and difference focus-dependent metric each comprise a spatial frequency metric related to a spatial frequency of the first zeroth order image and second zeroth order image.

12. A metrology device as claimed in any of claims 10 to 11, wherein said at least one detector is operable to detect non-zeroth order diffracted radiation on said detector; and
determine a parameter of interest from said non-zeroth order diffracted radiation.

13. A metrology device as claimed in claim 12, wherein said first zeroth order image, said second zeroth order image, a first diffraction order image of a first diffraction order of a pair of complementary diffraction orders and a second diffraction order image of a second diffraction order of the pair of complementary diffraction orders are detected on separate regions on said at least one detector.

14. A metrology device as claimed in claim 13, wherein said first diffraction order is a +1 diffraction order and said second diffraction order is a -1 diffraction order .

15. A method of determining a focus value of measurement radiation on a sample during a measurement of the sample, the method comprising:
separating scattered radiation from the sample, having scattered from the sample following illumination of the sample with said measurement radiation, into at least non-zeroth order diffracted radiation, a first portion of zeroth order radiation and a second portion of zeroth order radiation;
detecting at least one image of the non-zeroth order diffracted radiation, a first zeroth order image from the first portion of zeroth order radiation, and a second zeroth order image of the second portion of zeroth order radiation at separate regions of a detection plane;
imposing a defocus on at least one of said first portion of said zeroth order radiation and said second portion of said zeroth order radiation; and
determining the focus value of said measurement radiation on the sample from said first zeroth order image and a second zeroth order image.
